(19) Europäisches Patentamt
European Patent Office
Office européen des brevets

(11) EP 4 167 301 A1

(12) **EUROPEAN PATENT APPLICATION**
published in accordance with Art. 153(4) EPC

(43) Date of publication:
**19.04.2023 Bulletin 2023/16**

(21) Application number: **21821857.6**

(22) Date of filing: **07.06.2021**

(51) International Patent Classification (IPC):
***H01L 31/10** (2006.01)* ***H01L 27/144** (2006.01)*
***H01L 27/146** (2006.01)*

(52) Cooperative Patent Classification (CPC):
**H01L 27/144; H01L 27/146; H01L 31/10**

(86) International application number:
**PCT/JP2021/021470**

(87) International publication number:
**WO 2021/251309 (16.12.2021 Gazette 2021/50)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **12.06.2020 JP 2020102565**

(71) Applicant: **FUJIFILM Corporation**
**Tokyo 106-8620 (JP)**

(72) Inventor: **ONO Masashi**
**Haibara-gun, Shizuoka 421-0396 (JP)**

(74) Representative: **Hoffmann Eitle**
**Patent- und Rechtsanwälte PartmbB**
**Arabellastraße 30**
**81925 München (DE)**

(54) **SEMICONDUCTOR FILM, METHOD FOR MANUFACTURING SEMICONDUCTOR FILM, LIGHT DETECTION ELEMENT, AND IMAGE SENSOR**

(57) There is provided a semiconductor film including an aggregate of semiconductor quantum dots that contain a metal atom and a ligand that is coordinated to the semiconductor quantum dot, in which a half width at half maximum of an exciton absorption peak in optical characteristics of the semiconductor film is 60 nm or less. There are also provided a manufacturing method for a semiconductor film, a photodetector element, and an image sensor.

EP 4 167 301 A1

## Description

## BACKGROUND OF THE INVENTION

1. Field of the Invention

The present invention relates to a semiconductor film containing semiconductor quantum dots that contain a metal atom, a manufacturing method for a semiconductor film, a photodetector element, and an image sensor.

2. Description of the Related Art

In recent years, attention has been focused on photodetector elements capable of detecting light in the infrared region (infrared rays) in the fields such as smartphones, surveillance cameras, and in-vehicle cameras.

In the related art, a silicon photodiode in which a silicon wafer is used as a material of a photoelectric conversion layer has been used in a photodetector element that is used in an image sensor or the like. However, a silicon photodiode has low sensitivity in the infrared region having a wavelength of 900 nm or more.

In addition, an InGaAs-based semiconductor material known as a near-infrared light-receiving element has a problem in that it requires extremely high-cost processes such as epitaxial growth or a step of sticking a substrate in order to realize a high quantum efficiency, and thus it has not been widespread.

By the way, in recent years, research on semiconductor quantum dots has been advanced. A solar cell device, which has a semiconductor film containing PbS quantum dots treated with $ZnI_2$ and 3-mercaptopropionic acid as a photoelectric conversion layer, is disclosed in Santanu Pradhan, Alexandros Stavrinadis, Shuchi Gupta, Yu Bi, Francesco Di Stasio, and Gerasimos Konstantatos, "Trap-State Suppression and Improved Charge Transport in PbS Quantum Dot Solar Cells with Synergistic Mixed-Ligand Treatments", Small 13, 1700598 (2017).

## SUMMARY OF THE INVENTION

In recent years, with the demand for performance improvement of an image sensor and the like, further improvement of various characteristics that are required in a photodetector element used in the image sensor and the like is also required. For example, an image sensor may be used for a use application of selectively detecting and sensing light having a certain specific wavelength (for example, infrared rays or the like). As a result, an image sensor is required to have high sensitivity to light having a target wavelength.

In increasing the sensitivity for light having a target wavelength in an image sensor, it has been studied to use a photoelectric conversion film composed of a semiconductor film having a high external quantum efficiency as a photoelectric conversion film in a photodetector element.

As a result of carrying out studies on the semiconductor film described in Santanu Pradhan, Alexandros Stavrinadis, Shuchi Gupta, Yu Bi, Francesco Di Stasio, and Gerasimos Konstantatos, "Trap-State Suppression and Improved Charge Transport in PbS Quantum Dot Solar Cells with Synergistic Mixed-Ligand Treatments", Small 13, 1700598 (2017), the inventors of the present invention found that there is room for further improvement in external quantum efficiency.

Accordingly, an object of the present invention is to provide a semiconductor film having a high external quantum efficiency, a manufacturing method for a semiconductor film, a photodetector element, and an image sensor.

As a result of diligent studies on a semiconductor film containing an aggregate of semiconductor quantum dots that contain a metal atom and containing a ligand that is coordinated to the semiconductor quantum dot, the inventors of the present invention found that in a case of narrowing the half width at half maximum of an exciton absorption peak in optical characteristics of a semiconductor film, it is possible to improve the external quantum efficiency with respect to light having a wavelength in the vicinity of the exciton absorption peak, thereby completing the present invention. The present invention provides the following aspects.

<1> A semiconductor film comprising:

an aggregate of semiconductor quantum dots that contain a metal atom; and
a ligand that is coordinated to the semiconductor quantum dot,
in which a half width at half maximum of an exciton absorption peak in optical characteristics of the semiconductor film is 60 nm or less.

<2> The semiconductor film according to <1>, in which the semiconductor quantum dot is a semiconductor quantum dot that contains a lead atom.

<3> The semiconductor film according to <1>, in which the semiconductor quantum dot is a PbS quantum dot.
<4> The semiconductor film according to any one of <1> to <3>, in which the ligand contains a compound having a thiol group.
<5> The semiconductor film according to any one of <1> to <4>, in which the semiconductor quantum dot is a PbS quantum dot, the ligand contains a compound having a thiol group, and a ratio of the number of sulfur atoms to the number of lead atoms in the semiconductor film is 0.55 or more.
<6> The semiconductor film according to any one of <1> to <5>, in which the semiconductor quantum dot is a PbS quantum dot, the ligand contains a compound having a thiol group, and in a case where a value of a ratio of the number of sulfur atoms to the number of lead atoms in the PbS quantum dot is 1, a value of a ratio of the number of sulfur atoms to the number of lead atoms in the semiconductor film is 1.25 or more.
<7> The semiconductor film according to any one of <1> to <6>, in which the semiconductor quantum dot is a PbS quantum dot, the ligand contains a compound having a thiol group, and a ratio of the number of sulfur atoms in the ligand to the number of sulfur atoms in the PbS quantum dot is 0.25 or more.
<8> The semiconductor film according to any one of <4> to <7>, in which the compound having a thiol group is at least one selected from 3-mercaptopropionic acid, thioglycolic acid, ethanedithiol, or 2-aminoethanethiol.
<9> The semiconductor film according to any one of <1> to <8>, in which the ligand contains a metal halide.
<10> The semiconductor film according to any one of <5> to <8>, in which the ligand further contains a metal halide, and a ratio of the number of metal atoms in the metal halide to the number of lead atoms in the PbS quantum dot is 0.25 or more.
<11> The semiconductor film according to <9> or <10>, in which the metal halide contains a zinc atom.
<12> The semiconductor film according to any one of <9> to <11>, in which the metal halide contains an iodine atom.
<13> A manufacturing method for a semiconductor film, which is a manufacturing method for the semiconductor film according to <3>, the manufacturing method comprising:

a step of producing a PbS quantum dot dispersion liquid containing a PbS quantum dot, a first ligand coordinated to the PbS quantum dot, and a solvent;
a PbS quantum dot aggregate forming step of applying the PbS quantum dot dispersion liquid onto a substrate to form a film of an aggregate of the PbS quantum dots; and
a ligand exchange step of applying a ligand solution containing a second ligand different from the first ligand and containing a solvent onto the film of the aggregate of the PbS quantum dots, which is formed by the PbS quantum dot aggregate forming step, to exchange the first ligand coordinated to the semiconductor quantum dot with the second ligand contained in the ligand solution,
in which the step of producing the PbS quantum dot dispersion liquid includes carrying out a reaction at a ratio of 4 mol or more of a lead atom to 1 mol of a sulfur atom to produce the PbS quantum dot.

<14> A photodetector element comprising the semiconductor film according to any one of <1> to <12>.
<15> The photodetector element according to <14>, in which the photodetector element is a photodiode-type photodetector element.
<16> An image sensor comprising the photodetector element according to <14> or <15>.

According to the present invention, it is possible to provide a semiconductor film having a high external quantum efficiency, a manufacturing method for a semiconductor film, a photodetector element, and an image sensor.

## BRIEF DESCRIPTION OF THE DRAWINGS

Fig. 1 is a view illustrating an embodiment of a photodetector element.

## DESCRIPTION OF THE PREFERRED EMBODIMENTS

Hereinafter, the contents of the present invention will be described in detail.
In the present specification, "to" is used to mean that numerical values described before and after "to" are included as a lower limit value and an upper limit value, respectively.
In describing a group (an atomic group) in the present specification, in a case where a description of substitution and non-substitution is not provided, the description means the group includes a group (an atomic group) having a substituent as well as a group (an atomic group) having no substituent. For example, the "alkyl group" includes not only an alkyl group that does not have a substituent (an unsubstituted alkyl group) but also an alkyl group that has a substituent (a substituted alkyl group).

<Semiconductor film>

The semiconductor film according to the embodiment of the present invention is characterized by being a semiconductor film including an aggregate of semiconductor quantum dots that contain a metal atom and a ligand that is coordinated to the semiconductor quantum dot, in which a half width at half maximum of an exciton absorption peak in optical characteristics of the semiconductor film is 60 nm or less.

The semiconductor film according to the embodiment of the present invention has such characteristics, and thus it has a high external quantum efficiency with respect to light having a wavelength in the vicinity of the exciton absorption peak.

The half width at half maximum of the exciton absorption peak of the semiconductor film according to the embodiment of the present invention is preferably 10 to 60 nm, more preferably 10 to 55 nm, and still more preferably 10 to 50 nm.

The exciton absorption peak of the semiconductor film according to the embodiment of the present invention preferably is present in a wavelength range of 700 to 3000 nm, more preferably present in a wavelength range of 800 to 2,500 nm, still more preferably present in a wavelength range of 800 to 2,000 nm, and even still more preferably present in a wavelength range of 900 to 1,600 nm.

The semiconductor film having the above-described characteristics can be achieved by a method, for example, using a semiconductor quantum dot synthesized under a condition in which an amount of a metal atom is excessive in an excess amount, as the semiconductor quantum dot. For example, in a case of a PbS quantum dot, it can be achieved by a method, for example, using a PbS quantum dot synthesized under a condition in which an amount of a raw material containing a lead atom is excessive as compared with a raw material containing a sulfur atom (for example, 4 mol or more of a lead atom with respect to 1 mol of a sulfur atom). Although the detailed reason is unknown, it is presumed that in the semiconductor quantum dot synthesized in this way, metal atoms (lead atoms in a case of a PbS quantum dot) are segregated on the particle surface in the process of the reaction or the grain growth. As a result, it is presumed that a ligand is easily coordinated on the surface of the semiconductor quantum dot, and the particle shape or the particle diameter of the semiconductor quantum dot is easily made uniform. In addition, in a case where the ligand exchange is carried out at the time of manufacturing the semiconductor film, it is presumed that the ligand exchange is easily carried out and thus the ligand exchange can be carried out more uniformly in the entire film. As a result, it is presumed that the ratio (the ligand ratio) of the ligand coordinated on the surface of the semiconductor quantum dot can be increased by using such a semiconductor quantum dot. It is presumed that by increasing the ligand ratio, an increase in surface defects and the like can be suppressed, or the distance between the semiconductor quantum dots in the semiconductor film can be made more uniform, and as a result, the half width at half maximum of the exciton absorption peak can be narrowed, which enables an increase in external quantum efficiency.

In addition, the position of the exciton absorption peak of the semiconductor film can be easily adjusted by a method, for example, adjusting the kind or particle size of the semiconductor quantum dot. In a case where the exciton absorption peak of the semiconductor film is desired to be exhibited on the long wave side, for example, the particle diameter of the semiconductor quantum dot may be made relatively large with respect to the Bohr radius. In a case where it is desired to be exhibited on the short wave side, the particle diameter of the semiconductor quantum dot may be made relatively small with respect to the Bohr radius. For example, in a case of PbS quantum dots having an average particle diameter of 3 to 6 nm, a semiconductor film can be made to have the exciton absorption peak in a wavelength range of 900 to 1,600 nm.

It is noted that in the present specification, the half width at half maximum of the exciton absorption peak in optical characteristics of the semiconductor film is a value measured as follows. That is, a light transmittance spectrum T (λ) (unit: %) and a reflectivity spectrum R (λ) (unit: %)) of the semiconductor film are measured using a spectrophotometer. From these measurement results, the absorbance of the semiconductor film, from which the influence of surface reflection and the like has been excluded, is calculated from the following expression. From the spectrum of the obtained absorbance of the semiconductor film, the half width at half maximum of the exciton absorption peak is determined. It is noted that the first maximal peak at which the absorption value starts to increase from a state of being substantially zero is regarded as the exciton absorption peak in a case where the measurement wavelength is swept from the long wave side to the short wave side. Here, the absorption derived from a solvent or a ligand is not regarded as the exciton absorption peak.

$$A = \mathrm{Log}_{10}((100 - R)/T)$$

(A is the absorbance at a wavelength λ, R is the reflectivity (unit: %) at the wavelength λ, and T is the light transmittance (unit: %) at the wavelength λ.)

In the semiconductor film according to the embodiment of the present invention, it is preferable that the semiconductor quantum dot is a PbS quantum dot and the ligand contains a compound having a thiol group. It is more preferable that the ligand contains a compound having a thiol group and a metal halide.

Regarding the above-described semiconductor film, the ratio of the number of sulfur atoms to the number of lead atoms in the semiconductor film is preferably 0.55 or more, more preferably 0.57 or more, and still more preferably 0.60 or more. The upper limit thereof is preferably 1.5 or less and more preferably 1.0 or less. In such a semiconductor film, the ratio of the ligand coordinated on the surface of the semiconductor quantum dot is large and the external quantum efficiency is higher.

Regarding the above-described semiconductor film, in a case where the value of the ratio of the number of sulfur atoms to the number of lead atoms in the PbS quantum dot is 1, the value of the ratio of the number of sulfur atoms to the number of lead atoms in the semiconductor film is preferably 1.25 or more, more preferably 1.3 or more, still more preferably 1.4 or more, and even still more preferably 1.5 or more. The upper limit thereof is preferably 3.0 or less and more preferably 2.5 or less. In such a semiconductor film, the ratio of the ligand coordinated on the surface of the semiconductor quantum dot is large and the external quantum efficiency is higher.

The value of the ratio of the number of sulfur atoms to the number of lead atoms in the PbS quantum dot and the value of the ratio of the number of sulfur atoms to the number of lead atoms in the semiconductor film can be calculated by element analysis according to a method such as X-ray photoelectron spectroscopy (XPS).

In addition, regarding the above-described semiconductor film, the ratio of the number of sulfur atoms in the ligand to the number of sulfur atoms in the PbS quantum dot is preferably 0.25 or more, more preferably 0.35 or more, still more preferably 0.40 or more, and even still more preferably 0.45 or more. The upper limit thereof is preferably 1.5 or less and more preferably 1.0 or less. In such a semiconductor film, the ratio of the ligand coordinated on the surface of the semiconductor quantum dot is large and the external quantum efficiency is higher. The ratio of the number of sulfur atoms in the ligand to the number of sulfur atoms in the PbS quantum dot in the semiconductor film can be calculated according to the method described in Examples described later.

In a case where the ligand contains a metal halide, the ratio of the number of metal atoms in the metal halide to the number of lead atoms in the PbS quantum dot in the semiconductor film according to the embodiment of the present invention is preferably 0.25 or more, more preferably 0.27 or more, and still more preferably 0.30 or more. The upper limit thereof is preferably 1.0 or less and more preferably 0.8 or less. In addition, the metal halide that is used as a ligand preferably contains a zinc atom. The ratio of the number of zinc atoms in the metal halide to the number of lead atoms in the PbS quantum dot is preferably 0.25 or more, more preferably 0.27 or more, and still more preferably 0.30 or more. The upper limit thereof is preferably 1.0 or less and more preferably 0.8 or less. In such a semiconductor film, the ratio of the ligand coordinated on the surface of the semiconductor quantum dot is large and the external quantum efficiency is higher.

The thickness of the semiconductor film is not particularly limited; however, it is preferably 10 to 600 nm, more preferably 50 to 600 nm, still more preferably 100 to 600 nm, and even still more preferably 150 to 600 nm, from the viewpoint of obtaining high electrical conductivity. The upper limit of the thickness is preferably 550 nm or less, more preferably 500 nm or less, and still more preferably 450 nm or less.

The semiconductor film according to the embodiment of the present invention can be preferably used in the photoelectric conversion layer of the photodetector element. Hereinafter, the details of the semiconductor film according to the embodiment of the present invention will be described.

The semiconductor film according to the embodiment of the present invention includes aggregates of semiconductor quantum dots containing a metal atom. The aggregate of semiconductor quantum dots means a form in which a large number of semiconductor quantum dots (for example, 100 or more quantum dots per 1 $\mu m^2$) are arranged close to each other. In addition, the "semiconductor" in the present specification means a substance having a specific resistance value of $10^{-2}$ $\Omega$ cm or more and $10^{8}$ $\Omega$ cm or less.

The semiconductor quantum dot is a semiconductor particle containing a metal atom. It is noted that in the present invention, the metal atom also includes a metalloid atom represented by a Si atom. Examples of the semiconductor quantum dot material that constitutes the semiconductor quantum dot include a nano particle (a particle having a size of 0.5 nm or more and less than 100 nm) of a general semiconductor crystal [a) a Group IV semiconductor, b) a compound semiconductor of a Group IV to IV element, a Group III to V element, or a Group II to VI element, or c) a compound semiconductor consisting of a combination of three or more of a Group II element, a Group III element, a Group IV element, a Group V element, and a Group VI element].

The semiconductor quantum dot preferably contains at least one metal atom selected from a lead (Pb) atom, an indium (In) atom, a germanium (Ge) atom, a silicon (Si) atom, a cadmium (Cd) atom, a zinc (Zn) atom, a mercury (Hg) atom, an aluminum (Al) atom, a tin (Sn) atom, or a gallium (Ga) atom, more preferably contains at least one metal atom selected from a lead (Pb) atom, an indium (In) atom, a germanium (Ge) atom, or a silicon (Si) atom, and due to the reason that the effect of the present invention is easily obtained more remarkably, it still more preferably contains a lead (Pb) atom.

Specific examples of the semiconductor quantum dot material that constitutes the semiconductor quantum dot

include semiconductor materials having a relatively narrow band gap, such as PbS, PbSe, PbSeS, InN, InAs, Ge, InGaAs, CuInS, CuInSe, CuInGaSe, InSb, HgTe, HgCdTe, $Ag_2S$, $Ag_2Se$, $Ag_2Te$, SnS, SnSe, SnTe, Si, and InP. Among them, due to the reason that the absorption coefficient of light in the infrared region is large, the lifetime of photocurrent is long, the carrier mobility is large, and the like, the semiconductor quantum dot preferably contains PbS or PbSe and more preferably contains PbS, and it is particularly preferably PbS. That is, the semiconductor quantum dot is preferably a PbS quantum dot.

Further, regarding the PbS quantum dot, the ratio of the number of sulfur atoms to the number of lead atoms (the number of sulfur atoms/the number of lead atoms) is preferably 0.25 to 1.0, more preferably 0.25 to 0.7, still more preferably 0.25 to 0.65, even still more preferably 0.25 to 0.5, and particularly preferably 0.25 to 0.4. Since the ratio of the lead atom is large in such a PbS quantum dot, it is presumed that a large number of lead atoms are present on the surface of the PbS quantum dot. As a result, a ligand is easily adsorbed on the surface of the PbS quantum dot, the ratio (the ligand ratio) of the ligand coordinated on the surface of the PbS quantum dot can be increased, and the semiconductor film is made to have a higher external quantum efficiency.

The ratio of the number of sulfur atoms to the number of lead atoms in the PbS quantum dot can be calculated by quantifying each of the lead atom and the sulfur atom in the PbS quantum dot according to X-ray photoelectron spectroscopy (XPS) for a spin-coated film or drop-cast film of a PbS quantum dot dispersion liquid. In a case where a PbS quantum dot dispersion liquid containing a ligand containing a lead atom or a sulfur atom is used, the above ratio is calculated by immersing PbS quantum dots in a large excess of a protonic polar solvent to remove ligands from the PbS quantum dots or removing ligands from the PbS quantum dots by high-temperature annealing, and then quantifying each of the PB atom and the S atom in the PbS quantum dot according to XPS. The removal of the ligands from the PbS quantum dots can be confirmed by the fact that the Pb/S ratio of the PbS quantum dots does not change in a case where the immersion time or annealing time/temperature in methanol is changed.

The semiconductor quantum dot may be a material having a core-shell structure in which a semiconductor quantum dot material is made to the nucleus (the core) and the semiconductor quantum dot material is covered with a coating compound. Examples of the coating compound include ZnS, ZnSe, ZnTe, ZnCdS, CdS, and GaP.

The band gap of the semiconductor quantum dot is preferably 0.5 to 2.0 eV In a case where the semiconductor film according to the embodiment of the present invention is applied to the use application to a photodetector element application, more specifically to a photoelectric conversion layer of a photodetector element, it can be made into a photodetector element capable of detecting light of various wavelengths depending on the use application. For example, it is possible to obtain a photodetector element capable of detecting light in the infrared region. The upper limit of the band gap of the semiconductor quantum dot is preferably 1.9 eV or less, more preferably 1.8 eV or less, and still more preferably 1.5 eV or less. The lower limit of the band gap of the semiconductor quantum dot is preferably 0.6 eV or more and more preferably 0.7 eV or more.

The average particle diameter of the semiconductor quantum dots is preferably 2 to 15 nm. The average particle diameter of the semiconductor quantum dots is an average value of the particle diameters of ten semiconductor quantum dots which are randomly selected. A transmission electron microscope may be used for measuring the particle diameter of the semiconductor quantum dots.

Generally, a semiconductor quantum dot contains particles of various sizes from several nm to several tens of nm. In the semiconductor quantum dot, in a case where the average particle diameter of semiconductor quantum dots is reduced to a size equal to or smaller than the Bohr radius of the internal electrons, a phenomenon in which the band gap of the semiconductor quantum dot changes due to the quantum size effect occurs. In a case where the average particle diameter of semiconductor quantum dots is 15 nm or less, it is easy to control the band gap by the quantum size effect.

The semiconductor film according to the embodiment of the present invention contains a ligand that is coordinated to the semiconductor quantum dot. Examples of the ligand include a metal halide and a compound having a coordination moiety. The compound having a coordination moiety is preferably a compound (a polydentate ligand) including two or more coordination moieties. Examples of the coordination moiety contained in the compound having a coordination moiety include a thiol group, an amino group, a hydroxy group, a carboxy group, a sulfo group, a phospho group, and a phosphonate group. The compound having a coordination moiety is preferably a compound having a thiol group due to the reason that the compound is easily coordinated firmly on the surface of the metal atom of the semiconductor quantum dot. In particular, in a case where a PbS quantum dot is used as the semiconductor quantum dot, a ligand can be more firmly coordinated to the Pb atom on the surface of the semiconductor quantum dot. In addition, in a case where a polydentate ligand is used as the compound having a coordination moiety, the polydentate ligand is easily subjected to chelate coordination to the semiconductor quantum dot, and the peeling of the ligand from the semiconductor quantum dot can be suppressed more effectively, whereby excellent durability is obtained. Furthermore, in a case of being subjected to chelate coordination, steric hindrance between semiconductor quantum dots can be suppressed, and high electrical conductivity is easily obtained, whereby a high external quantum efficiency is obtained. In addition, in a case where a metal halide and a polydentate ligand are used in combination, a higher external quantum

efficiency is easily obtained. As described above, the polydentate ligand is presumed to be subjected to chelate coordination to the semiconductor quantum dot. Further, it is presumed that the metal halide is coordinated in the gap where the polydentate ligand is not coordinated, and thus it is presumed that the surface defects of the semiconductor quantum dot can be further reduced. As a result, it is presumed that the external quantum efficiency can be further improved.

Examples of the halogen atom contained in the metal halide include a fluorine atom, a chlorine atom, a bromine atom, and an iodine atom, and an iodine atom is preferable from the viewpoint of coordinating power. Examples of the metal atom contained in the metal halide include a zinc (Zn) atom, an indium (In) atom, and a cadmium (Cd) atom, where a zinc (Zn) atom is preferable. Specific examples of the metal halide include zinc iodide, zinc bromide, zinc chloride, indium iodide, indium bromide, indium chloride, cadmium iodide, cadmium bromide, and cadmium chloride, gallium iodide, gallium bromide, and gallium chloride, and zinc iodide is particularly preferable. It is noted that in the metal halide, the metal ion or the halogen ion may be dissociated and coordinated on the surface of the semiconductor quantum dot. To give a description with a specific example, in the case of zinc iodide, zinc iodide may be coordinated on the surface of the semiconductor quantum dot, or the iodine ion or the zinc ion may be coordinated on the surface of the semiconductor quantum dot.

Examples of the compound having a coordination moiety include a ligand represented by any of Formulae (A) to (C).

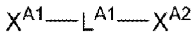

(A)

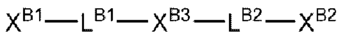

(B)

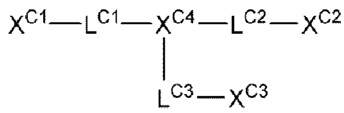

(C)

In Formula (A), $X^{A1}$ and $X^{A2}$ each independently represent a thiol group, an amino group, a hydroxy group, a carboxy group, a sulfo group, a phospho group, or a phosphonate group.

$L^{A1}$ represents a hydrocarbon group.

In Formula (B), $X^{B1}$ and $X^{B2}$ each independently represent a thiol group, an amino group, a hydroxy group, a carboxy group, a sulfo group, a phospho group, or a phosphonate group.

$X^{B3}$ represents S, O, or NH.

$L^{B1}$ and $L^{B2}$ each independently represent a hydrocarbon group.

In Formula (C), $X^{C1}$ to $X^{C3}$ each independently represent a thiol group, an amino group, a hydroxy group, a carboxy group, a sulfo group, a phospho group, or a phosphonate group.

$X^{C4}$ represents N.

$L^{C1}$ to $L^{C3}$ each independently represent a hydrocarbon group.

The amino group represented by $X^{A1}$, $X^{A2}$, $X^{B1}$, $X^{B2}$, $X^{C1}$, $X^{C2}$, or $X^{C3}$ is not limited to $-NH_2$ and includes a substituted amino group and a cyclic amino group as well. Examples of the substituted amino group include a monoalkylamino group, a dialkylamino group, a monoarylamino group, a diarylamino group, and an alkylarylamino group. The amino group represented by these groups is preferably $-NH_2$, a monoalkylamino group, or a dialkylamino group, and more preferably $-NH_2$.

The hydrocarbon group represented by $L^{A1}$, $L^{B1}$, $L^{B2}$, $L^{C1}$, $L^{C2}$, or $L^{C3}$ is preferably an aliphatic hydrocarbon group. The aliphatic hydrocarbon group may be a saturated aliphatic hydrocarbon group or may be an unsaturated aliphatic hydrocarbon group. The hydrocarbon group preferably has 1 to 20 carbon atoms. The upper limit of the number of carbon atoms is preferably 10 or less, more preferably 6 or less, and still more preferably 3 or less. Specific examples of the hydrocarbon group include an alkylene group, an alkenylene group, and an alkynylene group.

Examples of the alkylene group include a linear alkylene group, a branched alkylene group, and a cyclic alkylene group. A linear alkylene group or a branched alkylene group is preferable, and a linear alkylene group is more preferable. Examples of the alkenylene group include a linear alkenylene group, a branched alkenylene group, and a cyclic alkenylene group. A linear alkenylene group or a branched alkenylene group is preferable, and a linear alkenylene group is more preferable. Examples of the alkynylene group include a linear alkynylene group and a branched alkynylene group, and a linear alkynylene group is preferable. The alkylene group, the alkenylene group, and the alkynylene group may further have a substituent. The substituent is preferably a group having 1 or more and 10 or less of atoms. Preferred specific examples of the group having 1 or more and 10 or less of atoms include an alkyl group having 1 to 3 carbon atoms [a methyl group, an ethyl group, a propyl group, or an isopropyl group], an alkenyl group having 2 or 3 carbon atoms [an ethenyl group or a propenyl group], an alkynyl group having 2 to 4 carbon atoms [an ethynyl group, a propynyl group, or the like], a cyclopropyl group, an alkoxy group having 1 or 2 carbon atoms [a methoxy group or an ethoxy group], an acyl group having 2 or 3 carbon atoms [an acetyl group or a propionyl group], an alkoxycarbonyl group having 2 or 3 carbon atoms [a methoxycarbonyl group or an ethoxycarbonyl group], an acyloxy group having 2 carbon atoms [an

acetyloxy group], an acylamino group having 2 carbon atoms [an acetylamino group], a hydroxyalkyl group having 1 to 3 carbon atoms [a hydroxymethyl group, a hydroxyethyl group, or a hydroxypropyl group], an aldehyde group, a hydroxy group, a carboxy group, a sulfo group, a phospho group, a carbamoyl group, a cyano group, an isocyanate group, a thiol group, a nitro group, a nitroxy group, an isothiocyanate group, a cyanate group, a thiocyanate group, an acetoxy group, an acetamide group, a formyl group, a formyloxy group, a formamide group, a sulfamino group, a sulfino group, a sulfamoyl group, a phosphono group, an acetyl group, a halogen atom, and an alkali metal atom.

In Formula (A), $X^{A1}$ and $X^{A2}$ are separated by $L^{A1}$ preferably by 1 to 10 atoms, more preferably separated by 1 to 6 atoms, still more preferably separated by 1 to 4 atoms, even still more preferably separated by 1 to 3 atoms, and particularly preferably separated by 1 or 2 atoms.

In Formula (B), $X^{B1}$ and $X^{B3}$ are separated by $L^{B1}$ preferably by 1 to 10 atoms, more preferably separated by 1 to 6 atoms, still more preferably separated by 1 to 4 atoms, even still more preferably separated by 1 to 3 atoms, and particularly preferably separated by 1 or 2 atoms. In addition, $X^{B2}$ and $X^{B3}$ are separated by $L^{B2}$ preferably by 1 to 10 atoms, more preferably separated by 1 to 6 atoms, still more preferably separated by 1 to 4 atoms, even still more preferably separated by 1 to 3 atoms, and particularly preferably separated by 1 or 2 atoms.

In Formula (C), $X^{C1}$ and $X^{C4}$ are separated by $L^{C1}$ preferably by 1 to 10 atoms, more preferably separated by 1 to 6 atoms, still more preferably separated by 1 to 4 atoms, even still more preferably separated by 1 to 3 atoms, and particularly preferably separated by 1 or 2 atoms. In addition, $X^{C2}$ and $X^{C4}$ are separated by $L^{C2}$ preferably by 1 to 10 atoms, more preferably separated by 1 to 6 atoms, still more preferably separated by 1 to 4 atoms, even still more preferably separated by 1 to 3 atoms, and particularly preferably separated by 1 or 2 atoms. In addition, $X^{C3}$ and $X^{C4}$ are separated by $L^{C3}$ preferably by 1 to 10 atoms, more preferably separated by 1 to 6 atoms, still more preferably separated by 1 to 4 atoms, even still more preferably separated by 1 to 3 atoms, and particularly preferably separated by 1 or 2 atoms.

It is noted that the description that $X^{A1}$ and $X^{A2}$ are separated by $L^{A1}$ by 1 to 10 atoms means that the number of atoms constituting a molecular chain having the shortest distance, connecting $X^{A1}$ and $X^{A2}$, is 1 to 10 atoms. For example, in a case of Formula (A1), $X^{A1}$ and $X^{A2}$ are separated by two atoms, and in cases of Formulae (A2) and (A3), $X^{A1}$ and $X^{A2}$ are separated by 3 atoms. The numbers added to the following structural formulae represent the arrangement order of atoms constituting a molecular chain having the shortest distance, connecting $X^{A1}$ and $X^{A2}$.

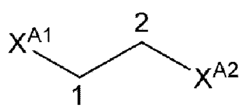
(A1)

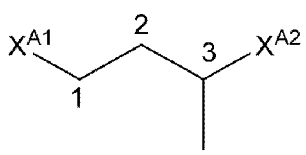
(A2)

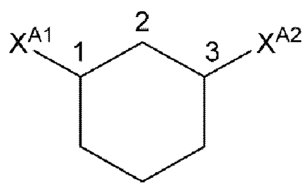
(A3)

To give a description with a specific compound, 3-mercaptopropionic acid is a compound (a compound having the following structure) having a structure in which a portion corresponding to $X^{A1}$ is a carboxy group, a portion corresponding to $X^{A2}$ is a thiol group, and a portion corresponding to $L^{A1}$ is an ethylene group. In 3-mercaptopropionic acid, $X^{A1}$ (the carboxy group) and $X^{A2}$ (the thiol group) are separated by $L^{A1}$ (the ethylene group) by two atoms.

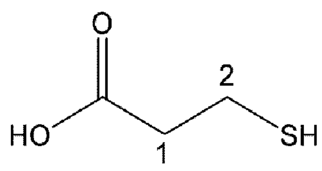

The same applies to the meanings that $X^{B1}$ and $X^{B3}$ are separated by $L^{B1}$ by 1 to 10 atoms, $X^{B2}$ and $X^{B3}$ are separated by $L^{B2}$ by 1 to 10 atoms, $X^{C1}$ and $X^{C4}$ are separated by $L^{C1}$ by 1 to 10 atoms, $X^{C2}$ and $X^{C4}$ are separated by $L^{C2}$ by 1 to 10 atoms, and $X^{C3}$ and $X^{C4}$ are separated by $L^{C3}$ by 1 to 10 atoms.

Specific examples of the compound having a coordination moiety include 3-mercaptopropionic acid, thioglycolic acid, ethanethiol, 2-aminoethanol, 2-aminoethanethiol, 2-mercaptoethanol, glycolic acid, ethylene glycol, ethylenediamine, aminosulfonic acid, glycine, aminomethylphosphonic acid, guanidine, diethylenetriamine, tris(2-aminoethyl)amine, 4-mercaptobutanoic acid, 3-aminopropanol, 3-mercaptopropanol, N-(3-aminopropyl)-1,3-propanediamine, 3-(bis(3-aminopropyl)amino)propan-1-ol,1-thioglycerol, dimercaprol, 1-mercapto-2-butanol, 1-mercapto-2-pentanol, 3-mercapto-1-propanol, 2,3-dimercapto-1-propanol, diethanolamine, 2-(2-aminoethyl)aminoethanol, dimethylenetriamine,

1,1-oxybismethylamine, 1,1-thiobismethylamine, 2-[(2-aminoethyl)amino]ethanethiol, bis(2-mercaptoethyl)amine, 2-aminoethane-1-thiol, 1-amino-2-butanol, 1-amino-2-pentanol, L-cysteine, D-cysteine, 3-amino-1-propanol, L-homoserine, D-homoserine, aminohydroxyacetic acid, L-lactic acid, D-lactic acid, L-malic acid, D-malic acid, glyceric acid, 2-hydroxybutyric acid, L-tartaric acid, D-tartaric acid, tartronic acid, and derivatives thereof. Among them, 3-mercaptopropionic acid, thioglycolic acid, ethanedithiol, 2-aminoethanol, or 2-aminoethanethiol is preferable, and thioglycolic acid is more preferable, due to the reason that a semiconductor film having a high external quantum efficiency can be easily obtained.

<Manufacturing method for semiconductor film>

A manufacturing method for a semiconductor film according to the embodiment of the present invention includes a step of producing a PbS quantum dot dispersion liquid containing a PbS quantum dot, a first ligand coordinated to the PbS quantum dot, and a solvent, a PbS quantum dot aggregate forming step of applying the PbS quantum dot dispersion liquid onto a substrate to form a film of an aggregate of the PbS quantum dots, and a ligand exchange step of applying a ligand solution containing a second ligand different from the first ligand and containing a solvent onto the film of the aggregate of the PbS quantum dots, which is formed by the PbS quantum dot aggregate forming step, to exchange the first ligand coordinated to the semiconductor quantum dot with the second ligand contained in the ligand solution, in which the step of producing the PbS quantum dot dispersion liquid includes carrying out a reaction at a ratio of 4 mol or more of a lead atom to 1 mol of a sulfur atom to produce the PbS quantum dot.

Each of the steps will be described in more detail below.

In the step of producing the PbS quantum dot dispersion liquid, a reaction is carried out at a ratio of 4 mol or more of the lead atom to 1 mol of the sulfur atom to produce the PbS quantum dot. The PbS quantum dot is produced by carrying out a reaction preferably at a ratio of 6 mol or more and more preferably at a ratio of 7 mol of the lead atom to 1 mol of the sulfur atom. Examples of the raw material containing a lead atom that is used for producing PbS quantum dots include lead oxide, a lead carboxylate (specifically, lead acetate), and lead chloride. In addition, examples of the raw material containing a sulfur atom include hexamethyldisilathiane, a trioctylphosphine solution of sulfur, and a thiol compound. These raw materials are subjected to a reaction at a ratio of 4 mol or more of the lead atom to 1 mol of the sulfur atom to produce PbS quantum dots.

A PbS quantum dot dispersion liquid can be produced by mixing the PbS quantum dots obtained in this way, the first ligand, and the solvent. The PbS quantum dot dispersion liquid may further contain other components as long as the effect of the present invention is not impaired.

The content of the PbS quantum dot in the PbS quantum dot dispersion liquid is preferably 1 to 500 mg/mL, more preferably 10 to 200 mg/mL, and still more preferably 20 to 100 mg/mL. In a case where the content of the PbS quantum dot in the PbS quantum dot dispersion liquid is 1 mg/mL or more, the density of the PbS quantum dot on the substrate becomes high, and thus a good film is easily obtained. On the other hand, in a case where the content of the PbS quantum dot is 500 mg/mL or less, the film thickness of the film obtained by applying the PbS quantum dot dispersion liquid one time is hardly increased. As a result, in the following ligand exchange step, it is possible to sufficiently carry out the ligand exchange of the first ligand coordinated to the PbS quantum dot present in the film.

The first ligand contained in the PbS quantum dot dispersion liquid acts as a ligand that is coordinated to the PbS quantum dot and has a molecular structure that easily causes steric hindrance, and thus it is preferable that the dispersant also serves as a dispersing agent that disperses PbS quantum dots in the solvent.

From the viewpoint of improving the dispersibility of PbS quantum dots, the first ligand is preferably a ligand having at least 6 or more carbon atoms in the main chain and is more preferably a ligand having 10 or more carbon atoms in the main chain. The first ligand may be any one of a saturated compound or an unsaturated compound. Specific examples of the first ligand include decanoic acid, lauric acid, myristic acid, palmitic acid, stearic acid, behenic acid, oleic acid, erucic acid, oleyl amine, dodecyl amine, dodecanethiol, 1,2-hexadecanethiol, trioctylphosphine oxide, and cetrimonium bromide. The first ligand is preferably one that hardly remains in the film after the formation of the semiconductor film. Specifically, it is preferable that the molecular weight thereof is small. The first ligand is preferably oleic acid or oleyl amine from the viewpoint of imparting the dispersion stability to the PbS quantum dots and hardly remaining on the semiconductor film.

The content of the first ligand in the PbS quantum dot dispersion liquid is preferably 0.1 mmol/L to 500 mmol/L and more preferably 0.5 mmol/L to 100 mmol/L with respect to the total volume of the PbS quantum dot dispersion liquid.

The solvent contained in the PbS quantum dot dispersion liquid is not particularly limited; however, it is preferably a solvent that is difficult to dissolve the PbS quantum dots and easily dissolves the first ligand. The solvent is preferably an organic solvent. Specific examples thereof include an alkane [n-hexane, n-octane, or the like], benzene, and toluene. In addition, the solvent contained in the PbS quantum dot dispersion liquid is also preferably a solvent that does not easily remain in the formed semiconductor film. In a case where the solvent has a relatively low boiling point, the content of the residual organic substance can be suppressed when the semiconductor film has finally been obtained. In addition,

the solvent is also preferably a solvent having good wettability to the substrate. For example, in a case where the PbS quantum dot dispersion liquid is applied onto a glass substrate, the solvent is preferably an alkane such as hexane or octane. The solvent contained in the PbS quantum dot dispersion liquid may be only one kind or may be a mixed solvent in which two or more kinds are mixed.

The content of the solvent in the PbS quantum dot dispersion liquid is preferably 50% to 99% by mass, more preferably 70% to 99% by mass, and still more preferably 90% to 98% by mass, with respect to the total mass of the PbS quantum dot dispersion liquid.

In the PbS quantum dot aggregate forming step, the PbS quantum dot dispersion liquid is applied onto a substrate to form a film of an aggregate of the PbS quantum dots.

The shape, structure, size, and the like of the substrate onto which the PbS quantum dot dispersion liquid is applied are not particularly limited, and the substrate can be appropriately selected depending on the intended purpose. The structure of the substrate may be a monolayer structure or a laminated structure. As the substrate, for example, a substrate composed of an inorganic material such as such, glass, or yttria-stabilized zirconia (YSZ), a resin, a resin composite material, or the like can be used. In addition, an electrode, an insulating film, or the like may be formed on the substrate. In that case, the PbS quantum dot dispersion liquid is applied onto the electrode or the insulating film on the substrate.

The method of applying a PbS quantum dot dispersion liquid onto a substrate is not particularly limited. Examples thereof include coating methods such as a spin coating method, a dipping method, an ink jet method, a dispenser method, a screen printing method, a relief printing method, an intaglio printing method, and a spray coating method.

The film thickness of the film of an aggregate of the PbS quantum dots, formed by the PbS quantum dot aggregate forming step, is preferably 3 nm or more, more preferably 10 nm or more, and still more preferably 20 nm or more. The upper limit thereof is preferably 200 nm or less, more preferably 150 nm or less, and still more preferably 100 nm or less.

In the ligand exchange step, a ligand solution containing a second ligand different from the first ligand and containing a solvent is applied onto the film of the aggregate of the PbS quantum dots, which is formed by the PbS quantum dot aggregate forming step, to exchange the first ligand coordinated to the semiconductor quantum dot with the second ligand contained in the ligand solution.

Examples of the second ligand include a metal halide and a compound including a coordination moiety. The second ligand preferably contains a compound having a thiol group and more preferably contains a compound having a thiol group and a metal halide. Examples of the details thereof include those described in the section of the semiconductor film described above, and the same applies to the preferred range thereof.

The ligand solution that is used in the ligand exchange step may contain only one kind of the second ligand or may contain two or more kinds thereof. In addition, two or more kinds of ligand solutions may be used.

The solvent contained in the ligand solution is preferably selected appropriately according to the kind of the ligand contained in the ligand solution, and it is preferably a solvent that easily dissolves the ligand. In addition, the solvent contained in the ligand solution is preferably an organic solvent having a high dielectric constant. Specific examples thereof include ethanol, acetone, methanol, acetonitrile, dimethylformamide, dimethyl sulfoxide, butanol, and propanol. In addition, the solvent contained in the ligand solution is preferably a solvent that does not easily remain in the formed semiconductor film. From the viewpoints of easy drying and easy removal by washing, a low boiling point alcohol, a ketone, or a nitrile is preferable, and methanol, ethanol, acetone, or acetonitrile is more preferable. The solvent contained in the ligand solution is preferably one that does not mix with the solvent contained in the PbS quantum dot dispersion liquid. Regarding the preferred solvent combination, in a case where the solvent contained in the PbS quantum dot dispersion liquid is an alkane such as hexane or octane, it is preferable to use a polar solvent such as methanol or acetone as the solvent contained in the ligand solution.

The method for applying the ligand solution onto the aggregate of PbS quantum dots is the same as the method for applying the PbS quantum dot dispersion liquid onto the substrate, and the same applies to the preferred aspect thereof.

A step (a rinsing step) of bringing a rinsing liquid into contact with a film after the ligand exchange step to rinse the film may be carried out. In a case where the rinsing step is carried out, it is possible to remove the excess ligand contained in the film and the ligand released from the quantum dots. In addition, it is possible to remove the remaining solvent and other impurities. The rinsing liquid is preferably an aprotic solvent due to the reason that it is easier to effectively remove excess ligands contained in the film and ligands released from the quantum dots, and it is easy to keep the film surface shape uniform by rearranging the surface of the quantum dots. Specific examples of the aprotic solvent include acetonitrile, acetone, methyl ethyl ketone, methyl isobutyl ketone, cyclopentanone, diethyl ether, tetrahydrofuran, cyclopentyl methyl ether, dioxane, ethyl acetate, butyl acetate, propylene glycol monomethyl ether acetate, hexane, octane, cyclohexane, benzene, toluene, chloroform, carbon tetrachloride, and dimethylformamide, where acetonitrile or tetrahydrofuran is preferable, and acetonitrile is more preferable.

In addition, the rinsing step may be carried out a plurality of times by using two or more kinds of rinsing liquids differing in polarity (relative permittivity). For example, it is preferable that, first, a rinsing liquid (also referred to as a first

rinsing liquid) having a high relative permittivity is used to carry out rinsing, and then a rinsing liquid (also referred to as a second rinsing liquid) having a relative permittivity lower than that of the first rinsing liquid is used to carry out rinsing. In a case of rinsing in this way, it is possible to first remove the excess component of the ligand A used in the ligand exchange, and then remove the released ligand component (the component that has been originally coordinated to the particles) generated in the ligand exchange process, and it is possible to more efficiently remove both the excess or the released ligand component.

The relative permittivity of the first rinsing liquid is preferably 15 to 50, more preferably 20 to 45, and still more preferably 25 to 40. The relative permittivity of the second rinsing liquid is preferably 1 to 15, more preferably 1 to 10, and still more preferably 1 to 5.

The manufacturing method for a semiconductor film may include a drying step. In a case of carrying out the drying step, it is possible to remove the solvent remaining on the semiconductor film. The drying time is preferably 1 to 100 hours, more preferably 1 to 50 hours, and still more preferably 5 to 30 hours. The drying temperature is preferably 10°C to 100°C, more preferably 20°C to 90°C, and still more preferably 20°C to 50°C. The oxygen concentration in the dry atmosphere is preferably 5% by volume or more, more preferably 10% by volume or more, and still more preferably 15% by volume or more.

A semiconductor film can be manufactured through such steps. The manufacturing method for a semiconductor film according to the embodiment of the present invention is preferably the above-described manufacturing method for a semiconductor film according to the present invention described above.

<Photodetector element>

The photodetector element according to the embodiment of the present invention includes the above-described semiconductor film according to the embodiment of the present invention. More preferably, the semiconductor film according to the embodiment of the present invention is included as the photoelectric conversion layer.

In the photodetector element, the thickness of the semiconductor film according to the embodiment of the present invention is preferably 10 to 600 nm, more preferably 50 to 600 nm, still more preferably 100 to 600 nm, and even still more preferably 150 to 600 nm. The upper limit of the thickness is preferably 550 nm or less, more preferably 500 nm or less, and still more preferably 450 nm or less.

Examples of the type of photodetector element include a photoconductor-type photodetector element and a photodiode-type photodetector element. Among the above, a photodiode-type photodetector element is preferable due to the reason that a high signal-to-noise ratio (SN ratio) is easily obtained.

Since the semiconductor film according to the embodiment of the present invention has excellent sensitivity to the light having a wavelength in the infrared region, the photodetector element according to the embodiment of the present invention is preferably used as a photodetector element that detects light having a wavelength in the infrared region. That is, the photodetector element according to the embodiment of the present invention is preferably used as an infrared photodetector element.

The light having a wavelength in the infrared region is preferably light having a wavelength of more than 700 nm, more preferably light having a wavelength of 800 nm or more, and still more preferably light having a wavelength of 900 nm or more. In addition, the light having a wavelength in the infrared region is preferably light having a wavelength of 2,000 nm or less and more preferably light having a wavelength of 1,600 nm or less.

The photodetector element may be a photodetector element that simultaneously detects light having a wavelength in the infrared region and light having a wavelength in the visible region (preferably light having a wavelength in a range of 400 to 700 nm).

Fig. 1 illustrates an embodiment of a photodiode-type photodetector element. It is noted that an arrow in the figure represents the incidence ray on the photodetector element. A photodetector element 1 illustrated in Fig. 1 includes a lower electrode 12, an upper electrode 11 opposite to the lower electrode 12, and a photoelectric conversion layer 13 provided between the lower electrode 12 and the upper electrode 11. The photodetector element 1 illustrated in Fig. 1 is used by causing light to be incident from above the upper electrode 11.

The photoelectric conversion layer 13 is composed of the above-described semiconductor film according to the embodiment of the present invention.

The refractive index of the photoelectric conversion layer 13 with respect to the light of the target wavelength to be detected by the photodetector element is preferably 2.0 to 3.0, more preferably 2.1 to 2.8, and still more preferably 2.2 to 2.7. According to this aspect, in a case where the photodetector element is adopted as a constitutional element of the photodiode, it is easy to realize a high light absorbance, that is, a high external quantum efficiency.

The thickness of the photoelectric conversion layer 13 is preferably 10 to 600 nm, more preferably 50 to 600 nm, still more preferably 100 to 600 nm, and even still more preferably 150 to 600 nm. The upper limit of the thickness is preferably 550 nm or less, more preferably 500 nm or less, and still more preferably 450 nm or less.

The wavelength $\lambda$ of the target light to be detected by the photodetector element and an optical path length $L^{\lambda}$

of the light having the wavelength $\lambda$ from a surface 12a of the lower electrode 12 on a side of the photoelectric conversion layer 13 to a surface 13a of the photoelectric conversion layer 13 on a side of the upper electrode preferably satisfy the relationship of Expression (1-1), and more preferably satisfy the relationship of Expression (1-2). In a case where the wavelength $\lambda$ and the optical path length $L^{\lambda}$ satisfy such a relationship, in the photoelectric conversion layer 13, it is possible to match phases of the light (the incidence ray) incident from the side of the upper electrode 11 and phases of the light (the reflected light) reflected on the surface of the lower electrode 12, and as a result, the light is intensified by the optical interference effect, whereby it is possible to obtain a higher external quantum efficiency.

$$0.05 + m/2 \leq L^{\lambda}/\lambda \leq 0.35 + m/2 \quad \cdots(1\text{-}1)$$

$$0.10 + m/2 \leq L^{\lambda}/\lambda \leq 0.30 + m/2 \quad \cdots(1\text{-}2)$$

In the above expressions, $\lambda$ is the wavelength of the target light to be detected by the photodetector element, $L^{\lambda}$ is the optical path length of light having a wavelength $\lambda$ from a surface 12a of the lower electrode 12 on a side of the photoelectric conversion layer 13 to a surface 13a of the photoelectric conversion layer 13 on a side of the upper electrode, and m is an integer of 0 or more.

m is preferably an integer of 0 to 4, more preferably an integer of 0 to 3, still more preferably an integer of 0 to 2, and particularly preferably 0 or 1.

Here, the optical path length means the product obtained by multiplying the physical thickness of a substance through which light transmits by the refractive index. To give a description with the photoelectric conversion layer 13 as an example, in a case where the thickness of the photoelectric conversion layer is denoted by $d^1$ and the refractive index of the photoelectric conversion layer with respect to the wavelength $\lambda^1$ is denoted by $N^1$, the optical path length of the light having a wavelength $\lambda^1$ and transmitting through the photoelectric conversion layer 13 is $N^1 \times d^1$. In a case where the photoelectric conversion layer 13 is composed of two or more laminated films or in a case where an interlayer described later is present between the photoelectric conversion layer 13 and the lower electrode 12, the integrated value of the optical path length of each layer is the optical path length $L^{\lambda}$.

The upper electrode 11 is preferably a transparent electrode formed of a conductive material that is substantially transparent with respect to the wavelength of the target light to be detected by the photodetector element. It is noted that in the present specification, the description of "substantially transparent" means that the light transmittance is 50% or more, preferably 60% or more, and particularly preferably 80% or more. Examples of the material of the upper electrode 11 include a conductive metal oxide. Specific examples thereof include tin oxide, zinc oxide, indium oxide, indium tungsten oxide, indium zinc oxide (IZO), indium tin oxide (ITO), and a fluorine-doped tin oxide (FTO).

The film thickness of the upper electrode 11 is not particularly limited, and it is preferably 0.01 to 100 μm, more preferably 0.01 to 10 μm, and particularly preferably 0.01 to 1 μm. It is noted that in the present invention, the film thickness of each layer can be measured by observing the cross section of the photodetector element 1 using a scanning electron microscope (SEM) or the like.

Examples of the material that forms the lower electrode 12 include a metal such as platinum, gold, nickel, copper, silver, indium, ruthenium, palladium, rhodium, iridium, osmium, or aluminum, the above-described conductive metal oxide, a carbon material, and a conductive polymer. The carbon material may be any material having conductivity, and examples thereof include fullerene, a carbon nanotube, graphite, and graphene.

The lower electrode 12 is preferably a thin film of a metal or conductive metal oxide (including a thin film formed by vapor deposition), or a glass substrate or plastic substrate having this thin film. The glass substrate or the plastic substrate is preferably glass having a thin film of gold or platinum, or glass on which platinum is vapor-deposited. The film thickness of the lower electrode 12 is not particularly limited, and it is preferably 0.01 to 100 μm, more preferably 0.01 to 10 μm, and particularly preferably 0.01 to 1 μm.

Although not illustrated in the drawing, a transparent substrate may be arranged on the surface of the upper electrode 11 on the light incidence side (the surface opposite to the side of the photoelectric conversion layer 13). Examples of the kind of transparent substrate include a glass substrate, a resin substrate, and a ceramic substrate.

In addition, although not illustrated in the drawing, an interlayer may be provided between the photoelectric conversion layer 13 and the lower electrode 12 and/or between the photoelectric conversion layer 13 and the upper electrode 11. Examples of the interlayer include a blocking layer, an electron transport layer, and a hole transport layer. Examples of the preferred aspect thereof include an aspect in which the hole transport layer is provided at any one of a gap between the photoelectric conversion layer 13 and the lower electrode 12 or a gap between the photoelectric conversion layer 13 and the upper electrode 11. It is more preferable that the electron transport layer is provided at any one of a gap between the photoelectric conversion layer 13 and the lower electrode 12 or a gap between the photoelectric

conversion layer 13 and the upper electrode 11, and the hole transport layer is provided at the other gap. The hole transport layer and the electron transport layer may be a single-layer film or a laminated film having two or more layers.

The blocking layer is a layer having a function of preventing a reverse current. The blocking layer is also called a short circuit prevention layer. Examples of the material that forms the blocking layer include silicon oxide, magnesium oxide, aluminum oxide, calcium carbonate, cesium carbonate, polyvinyl alcohol, polyurethane, titanium oxide, tin oxide, zinc oxide, niobium oxide, and tungsten oxide. The blocking layer may be a single-layer film or a laminated film having two or more layers.

The electron transport layer is a layer having a function of transporting electrons generated in the photoelectric conversion layer 13 to the upper electrode 11 or the lower electrode 12. The electron transport layer is also called a hole block layer. The electron transport layer is formed of an electron transport material capable of exhibiting this function. Examples of the electron transport material include a fullerene compound such as [6,6]-phenyl-C61-butyric acid methyl ester ($PC_{61}BM$), a perylene compound such as perylenetetracarboxylic diimide, tetracyanoquinodimethane, titanium oxide, tin oxide, zinc oxide, indium oxide, indium tungsten oxide, indium zinc oxide, indium tin oxide, and fluorine-doped tin oxide. The electron transport layer may be a single-layer film or a laminated film having two or more layers.

The hole transport layer is a layer having a function of transporting holes generated in the photoelectric conversion layer 13 to the upper electrode 11 or the lower electrode 12. The hole transport layer is also called an electron block layer. The hole transport layer is formed of a hole transport material capable of exhibiting this function. Examples of the hole transport material include poly(3,4-ethylenedioxythiophene):poly(4-styrenesulfonic acid) (PEDOT:PSS) and MoOs. In addition, the organic hole transport material disclosed in paragraph Nos. 0209 to 0212 of JP2001-291534A can also be used. In addition, a semiconductor quantum dot can also be used as the hole transport material. Examples of the semiconductor quantum dot material that constitutes the semiconductor quantum dot include a nano particle (a particle having a size of 0.5 nm or more and less than 100 nm) of a general semiconductor crystal [a) a Group IV semiconductor, b) a compound semiconductor of a Group IV to IV element, a Group III to V element, or a Group II to VI element, or c) a compound semiconductor consisting of a combination of three or more of a Group II element, a Group III element, a Group IV element, a Group V element, and a Group VI element]. Specific examples thereof include semiconductor materials having a relatively narrow band gap, such as PbS, PbSe, PbTe, PbSeS, InN, InAs, Ge, InGaAs, CuInS, CuInSe, CuInGaSe, InSb, HgTe, HgCdTe, $Ag_2S$, $Ag_2Se$, $Ag_2Te$, SnS, SnSe, SnTe, Si, and InP. A ligand may be coordinated on the surface of the semiconductor quantum dot.

<Image sensor>

The image sensor according to the embodiment of the present invention includes the above-described photodetector element according to the embodiment of the present invention. Since the photodetector element according to the embodiment of the present invention also has excellent sensitivity to light having a wavelength in the infrared region, it can be particularly preferably used as an infrared image sensor.

The configuration of the image sensor is not particularly limited as long as it has the photodetector element according to the embodiment of the present invention and it is a configuration that functions as an image sensor.

The image sensor invention may include an infrared transmitting filter layer. The infrared transmitting filter layer preferably has a low light transmittance in the wavelength range of the visible region, more preferably has an average light transmittance of 10% or less, still more preferably 7.5% or less, and particularly preferably 5% or less in a wavelength range of 400 to 650 nm.

Examples of the infrared transmitting filter layer include those composed of a resin film containing a coloring material. Examples of the coloring material include a chromatic coloring material such as a red coloring material, a green coloring material, a blue coloring material, a yellow coloring material, a purple coloring material, and an orange coloring material, and a black coloring material. It is preferable that the coloring material contained in the infrared transmitting filter layer forms a black color with a combination of two or more kinds of chromatic coloring materials or is a coloring material containing a black coloring material. Examples of the combination of the chromatic coloring material in a case of forming a black color by a combination of two or more kinds of chromatic coloring materials include the following aspects (C1) to (C7).

(C1) an aspect containing a red coloring material and a blue coloring material.
(C2) an aspect containing a red coloring material, a blue coloring material, and a yellow coloring material.
(C3) an aspect containing a red coloring material, a blue coloring material, a yellow coloring material, and a purple coloring material.
(C4) an aspect containing a red coloring material, a blue coloring material, a yellow coloring material, a purple coloring material, and a green coloring material.
(C5) an aspect containing a red coloring material, a blue coloring material, a yellow coloring material, and a green coloring material.

(C6) an aspect containing a red coloring material, a blue coloring material, and a green coloring material.
(C7) an aspect containing a yellow coloring material and a purple coloring material.

The chromatic coloring material may be a pigment or a dye. It may contain a pigment and a dye. The black coloring material is preferably an organic black coloring material. Examples of the organic black coloring material include a bisbenzofuranone compound, an azomethine compound, a perylene compound, and an azo compound.

The infrared transmitting filter layer may further contain an infrared absorber. In a case where the infrared absorber is contained in the infrared transmitting filter layer, the wavelength of the light to be transmitted can be shifted to the longer wave side. Examples of the infrared absorber include a pyrrolo pyrrole compound, a cyanine compound, a squarylium compound, a phthalocyanine compound, a naphthalocyanine compound, a quaterrylene compound, a merocyanine compound, a croconium compound, an oxonol compound, an iminium compound, a dithiol compound, a triarylmethane compound, a pyrromethene compound, an azomethine compound, an anthraquinone compound, a dibenzofuranone compound, a dithiolene metal complex, a metal oxide, and a metal boride.

The spectral characteristics of the infrared transmitting filter layer can be appropriately selected according to the use application of the image sensor. Examples of the filter layer include those that satisfy any one of the following spectral characteristics of (1) to (5).

(1): A filter layer in which the maximum value of the light transmittance in the film thickness direction in a wavelength range of 400 to 750 nm is 20% or less (preferably 15% or less and more preferably 10% or less), and the minimum value of the light transmittance in the film thickness direction in a wavelength range of 900 to 1,500 nm is 70% or more (preferably 75% or more and more preferably 80% or more).
(2): A filter layer in which the maximum value of the light transmittance in the film thickness direction in a wavelength range of 400 to 830 nm is 20% or less (preferably 15% or less and more preferably 10% or less), and the minimum value of the light transmittance in the film thickness direction in a wavelength range of 1,000 to 1,500 nm is 70% or more (preferably 75% or more and more preferably 80% or more).
(3): A filter layer in which the maximum value of the light transmittance in the film thickness direction in a wavelength range of 400 to 950 nm is 20% or less (preferably 15% or less and more preferably 10% or less), and the minimum value of the light transmittance in the film thickness direction in a wavelength range of 1,100 to 1,500 nm is 70% or more (preferably 75% or more and more preferably 80% or more).
(4): A filter layer in which the maximum value of the light transmittance in the film thickness direction in a wavelength range of 400 to 1,100 nm is 20% or less (preferably 15% or less and more preferably 10% or less), and the minimum value thereof in a wavelength range of 1,400 to 1,500 nm is 70% or more (preferably 75% or more and more preferably 80% or more).
(5): A filter layer in which the maximum value of the light transmittance in the film thickness direction in a wavelength range of 400 to 1,300 nm is 20% or less (preferably 15% or less and more preferably 10% or less), and the minimum value thereof in a wavelength range of 1,600 to 2,000 nm is 70% or more (preferably 75% or more and more preferably 80% or more).

Further, as the infrared transmitting filter, the films disclosed in JP2013-077009A, JP2014-130173A, JP2014-130338A, WO2015/166779A, WO2016/178346A, WO2016/190162A, WO2018/016232A, JP2016-177079A, JP2014-130332A, and WO2016/027798A can be used. As the infrared transmitting filter, two or more filters may be used in combination, or a dual bandpass filter that transmits through two or more specific wavelength ranges with one filter may be used.

The image sensor according to the embodiment of the present invention may include an infrared shielding filter for the intended purpose of improving various performances such as noise reduction. Specific examples of the infrared shielding filter include the filters disclosed in WO2016/186050A, WO2016/035695A, JP6248945B, WO2019/021767A, JP2017-067963A, and JP6506529B.

The image sensor according to the embodiment of the present invention may include a dielectric multi-layer film. Examples of the dielectric multi-layer film include those in which a plurality of layers are laminated by alternately laminating a dielectric thin film having a high refractive index (a high refractive index material layer) and a dielectric thin film having a low refractive index (a low refractive index material layer). The number of laminated layers of the dielectric thin film in the dielectric multi-layer film is not particularly limited; however, it is preferably 2 to 100 layers, more preferably 4 to 60 layers, and still more preferably 6 to 40 layers. The material that is used for forming the high refractive index material layer is preferably a material having a refractive index of 1.7 to 2.5. Specific examples thereof include $Sb_2O_3$, $Sb_2S_3$, $Bi_2O_3$, $CeO_2$, $CeF_3$, $HfO_2$, $La_2O_3$, $Nd_2O_3$, $Pr_6O_{11}$, $Sc_2O_3$, SiO, $Ta_2O_5$, $TiO_2$, TlCl, $Y_2O_3$, ZnSe, ZnS, and $ZrO_2$. The material that is used for forming the low refractive index material layer is preferably a material having a refractive index of 1.2 to 1.6. Specific examples thereof include $Al_2O_3$, $BiF_3$, $CaF_2$, $LaF_3$, $PbCl_2$, $PbF_2$, LiF, $MgF_2$, MgO, $NdF_3$, $SiO_2$, $Si_2O_3$, NaF, $ThO_2$, $ThF_4$, and $Na_3AlF_6$. The method for forming the dielectric multi-layer film is not particularly

limited; however, examples thereof include ion plating, a vacuum deposition method using an ion beam or the like, a physical vapor deposition method (a PVD method) such as sputtering, and a chemical vapor deposition method (a CVD method). The thickness of each of the high refractive index material layer and the low refractive index material layer is preferably 0.1 $\lambda$ to 0.5 $\lambda$ in a case where the wavelength of the light to be blocked is $\lambda$ (nm). Specific examples of the usable dielectric multi-layer film include the films disclosed in JP2014-130344A and JP2018-010296A.

In the dielectric multi-layer film, the transmission wavelength range is preferably present in the infrared region (preferably a wavelength range having a wavelength of more than 700 nm, more preferably a wavelength range having a wavelength of more than 800 nm, and still more preferably a wavelength range having a wavelength of more than 900 nm). The maximum transmittance in the transmission wavelength range is preferably 70% or more, more preferably 80% or more, and still more preferably 90% or more. In addition, the maximum transmittance in the shielding wavelength range is preferably 20% or less, more preferably 10% or less, and still more preferably 5% or less. In addition, the average transmittance in the transmission wavelength range is preferably 60% or more, more preferably 70% or more, and still more preferably 80% or more. In addition, in a case where the wavelength at which the maximum transmittance is exhibited is denoted by a central wavelength $\lambda_{t1}$, the wavelength range of the transmission wavelength range is preferably "the central wavelength $\lambda_{t1}$ $\pm$ 100 nm", more preferably "the central wavelength $\lambda_{t1}$ $\pm$ 75 nm", and still more preferably "the central wavelength $\lambda_{t1}$ $\pm$ 50 nm".

The dielectric multi-layer film may have only one transmission wavelength range (preferably, a transmission wavelength range having a maximum transmittance of 90% or more) or may have a plurality of transmission wavelength ranges.

The image sensor according to the embodiment of the present invention may include a color separation filter layer. Examples of the color separation filter layer include a filter layer including colored pixels. Examples of the kind of colored pixel include a red pixel, a green pixel, a blue pixel, a yellow pixel, a cyan pixel, and a magenta pixel. The color separation filter layer may include colored pixels having two or more colors or having only one color. It can be appropriately selected according to the use application and the intended purpose. For example, the filter disclosed in WO2019/039172A can be used.

In addition, in a case where the color separation layer includes colored pixels having two or more colors, the colored pixels of the respective colors may be adjacent to each other, or a partition wall may be provided between the respective colored pixels. The material of the partition wall is not particularly limited. Examples thereof include an organic material such as a siloxane resin or a fluororesin, and an inorganic particle such as a silica particle. In addition, the partition wall may be composed of a metal such as tungsten or aluminum.

In a case where the image sensor according to the embodiment of the present invention includes an infrared transmitting filter layer and a color separation layer, it is preferable that the color separation layer is provided on an optical path different from the infrared transmitting filter layer. In addition, it is also preferable that the infrared transmitting filter layer and the color separation layer are arranged two-dimensionally. The description that the infrared transmitting filter layer and the color separation layer are two-dimensionally arranged means that at least parts of both are present on the same plane.

The image sensor according to the embodiment of the present invention may include an interlayer such as a planarizing layer, an underlying layer, or an intimate attachment layer, an anti-reflection film, and a lens. As the anti-reflection film, for example, a film produced from the composition disclosed in WO2019/017280A can be used. As the lens, for example, the structure disclosed in WO2018/092600A can be used.

The image sensor according to the embodiment of the present invention can be preferably used as an infrared image sensor. In addition, the image sensor according to the embodiment of the present invention can be preferably used as a sensor that senses light having a wavelength of 900 to 2,000 nm and can be more preferably used as a sensor that senses light having a wavelength of 900 to 1,600 nm.

## Examples

Hereinafter, the present invention will be described more specifically with reference to Examples. Materials, amounts used, proportions, treatment details, treatment procedures, and the like shown in the following examples can be appropriately changed without departing from the gist of the present invention. Accordingly, a scope of the present invention is not limited to the following specific examples.

[Preparation of PbS quantum dot dispersion liquid]

(PbS quantum dot dispersion liquid 1)

5.8 ml of oleic acid, 7.8 mmol of lead oxide, 0.4 mL of oleylamine, and 27 mL of octadecene were weighed and taken in a flask and heated at 110°C under vacuum for 300 minutes to obtain a precursor solution. Then, the system

was made into a nitrogen flow state. Next, 1 mmol of hexamethyldisilathiane was injected into the precursor solution in the flask together with 9.6 mL of octadecene. Immediately after the injection, the solution in the flask was naturally cooled, and at a stage where the temperature of the solution reached 60°C, 1 mL of a 0.3 mmol/L lead chloride solution (solvent: oleylamine) was added thereto. The solution in the flask was cooled to 30°C, 10 mL of toluene was added thereto, and the solution was recovered. An excess amount of ethanol was added to the solution, centrifugation was carried out at 10,000 rpm for 10 minutes, and the precipitate was dispersed in octane to obtain a PbS quantum dot dispersion liquid 1 (40 mg/mL). The band gap of the PbS quantum dot in the obtained PbS quantum dot dispersion liquid 1 was estimated from light absorption measurement in the visible to infrared region by using an ultraviolet-visible-near infrared spectrophotometer (V-670, manufactured by JASCO Corporation), and it was approximately 1.2 eV

(PbS quantum dot dispersion liquid 2)

5.0 ml of oleic acid, 6.7 mmol of lead oxide, 0.4 mL of oleylamine, and 25 mL of octadecene were weighed and taken in a flask and heated at 110°C under vacuum for 300 minutes to obtain a precursor solution. Then, the system was made into a nitrogen flow state. Next, 1 mmol of hexamethyldisilathiane was injected into the precursor solution in the flask together with 9.6 mL of octadecene. Immediately after the injection, the solution in the flask was naturally cooled, and at a stage where the temperature of the solution reached 60°C, 1 mL of a 0.3 mmol/L lead chloride solution (solvent: oleylamine) was added thereto. The solution in the flask was cooled to 30°C, 10 mL of toluene was added thereto, and the solution was recovered. An excess amount of ethanol was added to the solution, centrifugation was carried out at 10,000 rpm for 10 minutes, and the precipitate was dispersed in octane to obtain a PbS quantum dot dispersion liquid 2 (40 mg/mL). The band gap of the PbS quantum dot in the obtained PbS quantum dot dispersion liquid 2 was estimated from light absorption measurement in the visible to infrared region by using an ultraviolet-visible-near infrared spectrophotometer (V-670, manufactured by JASCO Corporation), and it was approximately 1.2 eV.

(PbS quantum dot dispersion liquid 3)

1.41 ml of oleic acid, 2 mmol of lead oxide, and 38 mL of octadecene were weighed and taken in a flask and heated at 110°C under vacuum for 90 minutes to obtain a precursor solution. Then, the temperature of the solution was adjusted to 115°C, and the system was made into a nitrogen flow state. Next, 1 mmol of hexamethyldisilathiane was injected into the precursor solution in the flask together with 9.6 mL of octadecene. Immediately after the injection, the solution in the flask was naturally cooled, and at a stage where the temperature of the solution reached 30°C, 10 mL of toluene was added thereto and the solution was recovered. An excess amount of ethanol was added to the solution, centrifugation was carried out at 10,000 rpm for 10 minutes, and the precipitate was dispersed in octane to obtain a PbS quantum dot dispersion liquid 3 (40 mg/mL). The band gap of the PbS quantum dot in the obtained PbS quantum dot dispersion liquid 3 was estimated from light absorption measurement in the visible to infrared region by using an ultraviolet-visible-near infrared spectrophotometer (V-670, manufactured by JASCO Corporation), and it was approximately 1.2 eV

[Manufacture of semiconductor film]

(Example 1)

The PbS quantum dot dispersion liquid 1 was added dropwise onto a glass substrate or a silicon substrate, and spin coating was carried out at 2,500 rpm to obtain a PbS quantum dot aggregate film (a step 1). Next, as the ligand solution, a methanol solution of 3-mercaptopropionic acid (concentration: 0.01 v/v%) was added dropwise onto the PbS quantum dot aggregate film, subsequently allowed to stand for 10 seconds, and subjected to spin drying at 2,500 rpm for 10 seconds to subject the ligand coordinated to the PbS quantum dot to the ligand exchange with 3-mercaptopropionic acid. Next, as the rinsing liquid, acetonitrile was added dropwise onto the PbS quantum dot aggregate film and subjected to spin drying at 2,500 rpm for 20 seconds (a step 2). The operation of the step 1 and the step 2 as one cycle was repeated for 3 cycles to form a semiconductor film consisting of a PbS film to a thickness of 60 nm, in which 3-mercaptopropionic acid was coordinated to the PbS quantum dots as a ligand.

(Examples 2 to 5 and Comparative Example 1)

Semiconductor films of Examples 2 to 5 and Comparative Example 1 were manufactured according to the same method as Example 1 except that the used kind of the PbS quantum dot dispersion liquid, the used kind of the ligand solution, and used the kind of the rinsing liquid were respectively those described in the following table.

[Table 1]

| | Kind of PbS quantum dot dispersion liquid | Kind of ligand solution | Kind of rinsing liquid |
|---|---|---|---|
| Example 1 | PbS quantum dot dispersion liquid 1 | Methanol solution of 3-mercaptopropionic acid (concentration: 0.01 v/v%) | Acetonitrile |
| Example 2 | PbS quantum dot dispersion liquid 2 | Methanol solution of 3-mercaptopropionic acid (concentration: 0.01 v/v%) | Acetonitrile |
| Example 3 | PbS quantum dot dispersion liquid 1 | Methanol solution of thioglycolic acid (concentration: 0.01 v/v%)<br>Methanol solution of zinc iodide (concentration: 25 mM) | Acetonitrile |
| Example 4 | PbS quantum dot dispersion liquid 2 | Methanol solution of thioglycolic acid (concentration: 0.01 v/v%)<br>Methanol solution of zinc iodide (concentration: 25 mM) | Acetonitrile |
| Example 5 | PbS quantum dot dispersion liquid 1 | Methanol solution of 3-mercaptopropionic acid (concentration: 0.01 v/v%)<br>Methanol solution of zinc iodide (concentration: 25 mM) | Acetonitrile |
| Comparative Example 1 | PbS quantum dot dispersion liquid 3 | Methanol solution of 3-mercaptopropionic acid (concentration: 0.01 v/v%) | Methanol |

[Evaluation of semiconductor film]

<Half width at half maximum of exciton absorption peak of semiconductor film>

Regarding the semiconductor film formed on the glass substrate, the light transmittance spectrum T (λ) (unit: %) and the reflectivity spectrum R (λ) (unit: %)) of the semiconductor film were measured using a spectrophotometer. From these measurement results, the absorbance of the semiconductor film, from which the influence of surface reflection and the like had been excluded, was calculated from the following expression. From the spectrum of the obtained absorbance of the semiconductor film, the half width at half maximum of the exciton absorption peak was determined. It is noted that the first maximal peak at which the absorption value starts to increase from a state of being substantially zero was regarded as the exciton absorption peak in a case where the measurement wavelength is swept from the long wave side to the short wave side.

$$A = \mathrm{Log}_{10}((100 - R)/T)$$

(A is the absorbance at a wavelength λ, R is the reflectivity (unit: %) at the wavelength λ, and T is the light transmittance (unit: %) at the wavelength λ.)

<Measurement of element ratio in semiconductor film>

Regarding the semiconductor film formed on the silicon substrate, the element ratio in the semiconductor film was measured by X-ray photoelectron spectroscopy (XPS) using an X-ray photoelectron spectroscopic analysis apparatus. The measurement conditions are as follows. It is noted that the evaluation was carried out with the Pb4f (7/2) orbital being focused on as the energy position correction.

The semiconductor film on the substrate was scanned (subjected to an Area measurement) over a region of 300 μm square with an X-ray (diameter: 100 μm) using the Kα ray of the aluminum as an X-ray source (output: 25 W, voltage: 15 kV), thereby measuring the composition ratio. At this time, the Pass Energy was measured under the conditions of 55 eV, charge correction (a combined use of an electron gun and a low-speed ion gun), and a photoelectron extraction angle of 45 deg.

Regarding the measurement, any two points in the semiconductor film were measured, and from the composition average value therefrom, each of the ratio (the S/Pb ratio 1) of the number of sulfur atoms to the number of lead atoms and the ratio (the Zn/Pb ratio) of zinc atoms to the number of lead atoms in the semiconductor film was calculated. It is noted that the lead atom in the semiconductor film is derived from the PbS quantum dot, and the zinc atom in the semiconductor film is derived from zinc iodide used as the ligand. In addition, the sulfur atom in the semiconductor film is derived from the PbS quantum dot and the ligand.

<Measurement of element ratio in PbS quantum dot>

The ratio (the S/Pb ratio 2) of the number of sulfur atoms to the number of lead atoms in the PbS quantum dot was calculated according to the following method. That is, a PbS quantum dot dispersion liquid was concentrated to 40 mg/mL and then about 10 to 20 μL thereof was dropped on a silicon substrate to produce a drop-cast film. This film was subjected to an XPS measurement under the same conditions as described above to quantify each of the lead atom and the sulfur atom in the PbS quantum dot, whereby the ratio (the S/Pb ratio 2) of the number of sulfur atoms to the number of lead atoms in the PbS quantum dot was calculated.

<Measurement of ratio (sulfur atom ratio) of number of sulfur atoms in ligand to number of sulfur atoms in PbS quantum dot>

The ratio (the sulfur atom ratio) of the number of sulfur atoms in the ligand to the number of sulfur atoms in the PbS quantum dot was calculated using the following expression.

$$\text{Sulfur atom ratio} = (\text{S/Pb ratio 1} - \text{S/Pb ratio 2})/(\text{S/Pb ratio 2})$$

<Value (ratio A) of ratio of number of sulfur atoms to number of lead atoms in PbS quantum dot in a case where value of ratio of number of sulfur atoms to number of lead atoms in semiconductor film is set to 1>

The value (the ratio A) of the ratio of the number of sulfur atoms to the number of lead atoms in the PbS quantum dot in a case where the value of the ratio of the number of sulfur atoms to the number of lead atoms in the semiconductor film is set to 1 was calculated using the following expression.

$$\text{Ratio A} = (\text{S/Pb ratio 1})/(\text{S/Pb ratio 2})$$

[Table 2]

| | Half width at half maximum (nm) | S/Pb ratio 1 | S/Pb ratio 2 | Sulfur atom ratio | Zn/Pb ratio | Ratio A |
|---|---|---|---|---|---|---|
| Example 1 | 44 | 0.63 | 0.39 | 0.63 | - | 1.63 |
| Example 2 | 49 | 0.57 | 0.40 | 0.43 | - | 1.43 |
| Example 3 | 44 | 0.62 | 0.39 | 0.60 | 0.32 | 1.60 |
| Example 4 | 48 | 0.58 | 0.40 | 0.45 | 0.30 | 1.45 |
| Example 5 | 45 | 0.61 | 0.39 | 0.58 | 0.31 | 1.58 |
| Comparative Example 1 | 69 | 0.51 | 0.42 | 0.21 | - | 1.21 |

All of the semiconductor films of Examples had an exciton absorption peak in the vicinity of a wavelength of 1,000 nm. In addition, the half width at half maximum of the exciton absorption peak was 60 nm or less.

[Manufacture of photodetector element]

(Example 11)

An indium tin oxide (ITO) film having a thickness of 100 nm and a titanium oxide film having a thickness of 20

nm were continuously formed on quartz glass by sputtering.

Next, the step 1 and the step 2 were carried out on the titanium oxide film by the same method as in Example 1. The operation of the step 1 and the step 2 as one cycle was repeated for 10 cycles to form a photoelectric conversion film having a thickness of 220 nm, consisting of a semiconductor film in which 3-mercaptopropionic acid was coordinated to the PbS quantum dots as a ligand.

Next, the above-described PbS quantum dot dispersion liquid 1 was added dropwise onto this photoelectric conversion layer, and spin coating was carried out at 2,500 rpm to form a PbS quantum dot aggregate film (a step HT1). Subsequently, as the ligand solution, an acetonitrile solution of ethanedithiol (concentration: 0.02 v/v%) was added dropwise onto this semiconductor quantum dot aggregate film, and then the film was allowed to stand for 30 seconds and subjected to spin drying at 2,500 rpm for 10 seconds. Next, acetonitrile was added dropwise onto the PbS quantum dot aggregate film, and spin drying was carried out at 2,500 rpm for 20 seconds to carry out the ligand exchange of the ligand coordinated to the PbS quantum dot to ethanedithiol (a step HT2). The operation of the step HT1 and step HT2 as one cycle was repeated for two cycles, and a hole transport layer, which was the PbS quantum dot aggregate film in which the ligand had been exchanged to ethanedithiol, was formed to a thickness of 40 nm.

Next, the formed laminate was dried in a glove box for 10 hours, and then a vacuum deposition method through a metal mask was used to form a metal electrode on the hole transport layer at a thickness of 100 nm by vapor deposition, thereby manufacturing a photodiode-type photodetector element of Example 11.

(Examples 12 to 15 and Comparative Example 11)

Photodetector elements of Examples 12 to 15 and Comparative Example 11 were manufactured according to the same method as in Example 11 except that the kind of the PbS quantum dot dispersion liquid, the kind of the ligand solution, and the kind of the rinsing liquid, which had been used in the step of forming the photoelectric conversion film, were respectively changed to those described in the following table, and the kind of the PbS quantum dot dispersion liquid, the kind of the ligand solution, and the kind of the rinsing liquid, which had been used in the step of forming the hole transport layer, were respectively changed to those described in the following table.

It is noted that the photoelectric conversion films of Examples 11 to 15 and Comparative Example 11 are respectively the same as the semiconductor films of Examples 1 to 5 and Comparative Example 1. As a result, in the photoelectric conversion films of Examples 11 to 15 and Comparative Example 11, the values of the half width at half maximum of the exciton absorption peak, the ratio (the S/Pb ratio 1) of the number of sulfur atoms to the number of lead atoms in the photoelectric conversion film, the ratio (the Zn/Pb ratio) of the number of zinc atoms to the number of lead atoms in the photoelectric conversion film, the ratio (the S/Pb ratio 2) of the number of sulfur atoms to the number of lead atoms in the PbS quantum dot, and the ratio (the S/Pb ratio 3) of the number of sulfur atoms in the ligand to the number of lead atoms in the PbS quantum dot are respectively the same as the values of the semiconductor films of Examples 1 to 5 and Comparative Example 1.

[Table 3]

| | | Kind of PbS quantum dot dispersion liquid | Kind of ligand solution | Kind of rinsing liquid |
|---|---|---|---|---|
| Example 11 | Photoelectric conversion film | PbS quantum dot dispersion liquid 1 | Methanol solution of 3-mercaptopropionic acid (concentration: 0.01 v/v%) | Acetonitrile |
| | Hole transport layer | PbS quantum dot dispersion liquid 1 | Acetonitrile solution of ethanedithiol (concentration: 0.02 v/v%) | Acetonitrile |
| Example 12 | Photoelectric conversion film | PbS quantum dot dispersion liquid 2 | Methanol solution of 3-mercaptopropionic acid (concentration: 0.01 v/v%) | Acetonitrile |
| | Hole transport layer | PbS quantum dot dispersion liquid 2 | Acetonitrile solution of ethanedithiol (concentration: 0.02 v/v%) | Acetonitrile |

(continued)

| | | Kind of PbS quantum dot dispersion liquid | Kind of ligand solution | Kind of rinsing liquid |
|---|---|---|---|---|
| Example 13 | Photoelectric conversion film | PbS quantum dot dispersion liquid 1 | Methanol solution of thioglycolic acid (concentration: 0.01 v/v%) Methanol solution of zinc iodide (concentration: 25 mM) | Acetonitrile |
| | Hole transport layer | PbS quantum dot dispersion liquid 1 | Acetonitrile solution of ethanedithiol (concentration: 0.02 v/v%) | Acetonitrile |
| Example 14 | Photoelectric conversion film | PbS quantum dot dispersion liquid 2 | Methanol solution of thioglycolic acid (concentration: 0.01 v/v%) Methanol solution of zinc iodide (concentration: 25 mM) | Acetonitrile |
| | Hole transport layer | PbS quantum dot dispersion liquid 2 | Acetonitrile solution of ethanedithiol (concentration: 0.02 v/v%) | Acetonitrile |
| Example 15 | Photoelectric conversion film | PbS quantum dot dispersion liquid 1 | Methanol solution of 3-mercaptopropionic acid (concentration: 0.01 v/v%) Methanol solution of zinc iodide (concentration: 25 mM) | Acetonitrile |
| | Hole transport layer | PbS quantum dot dispersion liquid 1 | Acetonitrile solution of ethanedithiol (concentration: 0.02 v/v%) | Acetonitrile |
| Comparative Example 11 | Photoelectric conversion film | PbS quantum dot dispersion liquid 3 | Methanol solution of 3-mercaptopropionic acid (concentration: 0.01 v/v%) | Methanol |
| | Hole transport layer | PbS quantum dot dispersion liquid 3 | Acetonitrile solution of ethanedithiol (concentration: 0.02 v/v%) | Acetonitrile |

<Evaluation>

External quantum efficiency was measured for each of the manufactured photodetector elements by using a semiconductor parameter analyzer (C4156, manufactured by Agilent Technologies, Inc.). First, the current-voltage characteristics (I-V characteristics) were measured while sweeping the voltage from 0 V to -2 V in a state of not carrying out irradiation with light. Here, the current value at -1 V was defined as a dark current. Subsequently, the I-V characteristics were measured while sweeping the voltage from 0 V to -2 V in a state of carrying out irradiation with monochrome light of 1,000 nm. The external quantum efficiency was calculated from the photocurrent value in a case where -1 V was applied. The evaluation results are shown in the table below. The table below also collectively shows the half width at half maximum of the exciton absorption peak of each photoelectric conversion film, the ratio (the S/Pb ratio 1) of the number of sulfur atoms to the number of lead atoms in the photoelectric conversion film, the ratio (the Zn/Pb ratio) of the number of zinc atoms to the number of lead atoms in the photoelectric conversion film, the ratio (the S/Pb ratio 2) of the number of sulfur atoms to the number of lead atoms in the PbS quantum dot, the ratio (the sulfur atom ratio) of the number of sulfur atoms in the ligand to the number of sulfur atoms in the PbS quantum dot, and the value (the ratio A) of the ratio of the number of sulfur atoms to the number of lead atoms in the PbS quantum dot in a case where the value of the ratio of the number of sulfur atoms to the number of lead atoms in the semiconductor film is set to 1.

[Table 4]

| | Photoelectric conversion film | | | | | | External quantum efficiency (%) |
|---|---|---|---|---|---|---|---|
| | Half width at half maximum (nm) | S/Pb ratio 1 | S/Pb ratio 2 | Sulfur atom ratio | Zn/Pb ratio | ratio A | |
| Example 11 | 44 | 0.63 | 0.39 | 0.63 | - | 1.63 | 59 |
| Example 12 | 49 | 0.57 | 0.40 | 0.43 | - | 1.43 | 57 |
| Example 13 | 44 | 0.62 | 0.39 | 0.60 | 0.32 | 1.60 | 66 |
| Example 14 | 48 | 0.58 | 0.40 | 0.45 | 0.30 | 1.45 | 61 |
| Example 15 | 45 | 0.61 | 0.39 | 0.58 | 0.31 | 1.58 | 62 |
| Comparative Example 11 | 69 | 0.51 | 0.42 | 0.21 | | 1.21 | 43 |

As shown in the above table, it has been confirmed that the external quantum efficiency of the photodetector elements of Examples 11 to 15 was significantly high as compared with the external quantum efficiency of Comparative Example 11. In addition, the photodetector elements of Examples 11 to 15 are excellent in infrared imaging performance as compared with the photodetector elements of Comparative Example 11.

In a case where an image sensor is produced by a known method by using the photodetector element obtained in Example described and incorporating it into a solid-state imaging element together with an optical filter produced according to the methods disclosed in WO2016/186050A and WO2016/190162A, it is possible to obtain an image sensor having good visible and infrared imaging performance.

Explanation of References

1: photodetector element
11: upper electrode
12: lower electrode
13: photoelectric conversion layer

**Claims**

**1.** A semiconductor film comprising:

an aggregate of semiconductor quantum dots that contain a metal atom; and
a ligand that is coordinated to the semiconductor quantum dot,
wherein a half width at half maximum of an exciton absorption peak in optical characteristics of the semiconductor film is 60 nm or less.

**2.** The semiconductor film according to claim 1,
wherein the semiconductor quantum dot is a semiconductor quantum dot that contains a lead atom.

**3.** The semiconductor film according to claim 1,
wherein the semiconductor quantum dot is a PbS quantum dot.

**4.** The semiconductor film according to any one of claims 1 to 3,
wherein the ligand contains a compound having a thiol group.

**5.** The semiconductor film according to any one of claims 1 to 4,

wherein the semiconductor quantum dot is a PbS quantum dot,
the ligand contains a compound having a thiol group, and

a ratio of the number of sulfur atoms to the number of lead atoms in the semiconductor film is 0.55 or more.

**6.** The semiconductor film according to any one of claims 1 to 5,

wherein the semiconductor quantum dot is a PbS quantum dot,
the ligand contains a compound having a thiol group, and
in a case where a value of a ratio of the number of sulfur atoms to the number of lead atoms in the PbS quantum dot is 1, a value of a ratio of the number of sulfur atoms to the number of lead atoms in the semiconductor film is 1.25 or more.

**7.** The semiconductor film according to any one of claims 1 to 6,

wherein the semiconductor quantum dot is a PbS quantum dot,
the ligand contains a compound having a thiol group, and
a ratio of the number of sulfur atoms in the ligand to the number of sulfur atoms in the PbS quantum dot is 0.25 or more.

**8.** The semiconductor film according to any one of claims 4 to 7,
wherein the compound having a thiol group is at least one selected from 3-mercaptopropionic acid, thioglycolic acid, ethanedithiol, or 2-aminoethanethiol.

**9.** The semiconductor film according to any one of claims 1 to 8,
wherein the ligand contains a metal halide.

**10.** The semiconductor film according to any one of claims 5 to 8,

wherein the ligand further contains a metal halide, and
a ratio of the number of metal atoms in the metal halide to the number of lead atoms in the PbS quantum dot is 0.25 or more.

**11.** The semiconductor film according to claim 9 or 10,
wherein the metal halide contains a zinc atom.

**12.** The semiconductor film according to any one of claims 9 to 11,
wherein the metal halide contains an iodine atom.

**13.** A manufacturing method for a semiconductor film, which is a manufacturing method for the semiconductor film according to claim 3, the manufacturing method comprising:

a step of producing a PbS quantum dot dispersion liquid containing a PbS quantum dot, a first ligand coordinated to the PbS quantum dot, and a solvent;
a PbS quantum dot aggregate forming step of applying the PbS quantum dot dispersion liquid onto a substrate to form a film of an aggregate of the PbS quantum dots; and
a ligand exchange step of applying a ligand solution containing a second ligand different from the first ligand and containing a solvent onto the film of the aggregate of the PbS quantum dots, which is formed by the PbS quantum dot aggregate forming step, to exchange the first ligand coordinated to the semiconductor quantum dot with the second ligand contained in the ligand solution,
wherein the step of producing the PbS quantum dot dispersion liquid includes carrying out a reaction at a ratio of 4 mol or more of a lead atom to 1 mol of a sulfur atom to produce the PbS quantum dot.

**14.** A photodetector element comprising the semiconductor film according to any one of claims 1 to 12.

**15.** The photodetector element according to claim 14,
wherein the photodetector element is a photodiode-type photodetector element.

**16.** An image sensor comprising the photodetector element according to claim 14 or 15.

FIG. 1

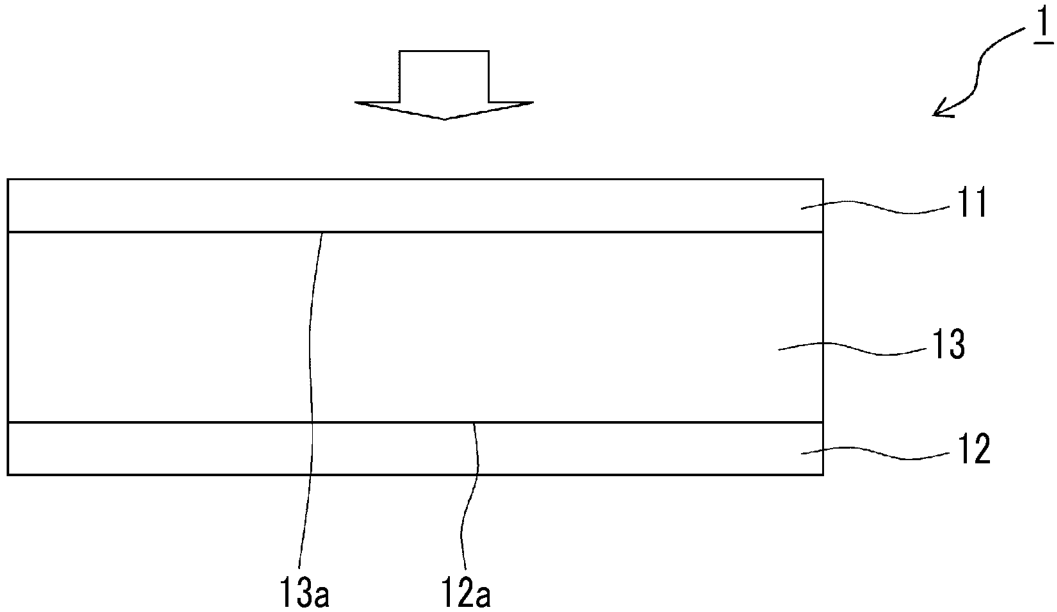

**INTERNATIONAL SEARCH REPORT**

International application No. PCT/JP2021/021470

A. CLASSIFICATION OF SUBJECT MATTER
H01L 31/10(2006.01)i; H01L 27/144(2006.01)i; H01L 27/146(2006.01)i
FI: H01L31/10 A; H01L27/144 K; H01L27/146 D
According to International Patent Classification (IPC) or to both national classification and IPC

B. FIELDS SEARCHED
Minimum documentation searched (classification system followed by classification symbols)
H01L31/00-31/20; H01L27/14-27/148

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)
JSTPlus/JST7580 (JDreamIII); Wiley Online Library

C. DOCUMENTS CONSIDERED TO BE RELEVANT

| Category* | Citation of document, with indication, where appropriate, of the relevant passages | Relevant to claim No. |
|---|---|---|
| X<br>Y | JP 2018-529214 A (UNIVERSITY OF FLORIDA RESEARCH FOUNDATION, INCORPORATED) 04 October 2018 (2018-10-04) claims 1-73, paragraphs [0002], [0047], [0085]-[0091], [0105]-[0109], fig. 1, 4-8 | 1-4, 13-16<br>5-12 |
| Y | PRADHAN, S. et al., "Trap-State Suppression and Improved Charge Transport in PbS Quantum Dot Solar Cells with Synergistic Mixed-Ligand Treatments", small, 2017, vol. 13, Article Number 1700598, pp. 1-9 in particular, abstract, page 4, right column, lines 8-12, table 2 | 5-12 |
| A | WO 2019/150989 A1 (SONY CORP.) 08 August 2019 (2019-08-08) paragraph [0034] | 1-16 |
| A | JP 2017-516320 A (MASSACHUSETTS INSTITUTE OF TECHNOLOGY) 15 June 2017 (2017-06-15) | 1-16 |

☐ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 29 July 2021 (29.07.2021) | 10 August 2021 (10.08.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application No.
PCT/JP2021/021470

| Patent Documents referred in the Report | Publication Date | Patent Family | Publication Date |
|---|---|---|---|
| JP 2018-529214 A | 04 Oct. 2018 | US 2019/0006541 A1<br>claims 1-73,<br>paragraphs [0002],<br>[0075], [0113]-<br>[0119], [0133]-<br>[0142], fig. 1, 4-8B<br>WO 2017/039774 A2<br>CA 2988784 A1<br>CN 107636431 A<br>KR 10-2018-0018660 A | |
| WO 2019/150989 A1 | 08 Aug. 2019 | US 2021/0057168 A1<br>paragraph [0056]<br>CN 111630668 A | |
| JP 2017-516320 A | 15 Jun. 2017 | US 2017/0271604 A1<br>WO 2015/172019 A1<br>CA 2948486 A1<br>KR 10-2017-0028306 A<br>CN 106660784 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001291534 A
- JP 2013077009 A
- JP 2014130173 A
- JP 2014130338 A
- WO 2015166779 A
- WO 2016178346 A
- WO 2016190162 A
- WO 2018016232 A
- JP 2016177079 A
- JP 2014130332 A
- WO 2016027798 A
- WO 2016186050 A
- WO 2016035695 A
- JP 6248945 B
- WO 2019021767 A
- JP 2017067963 A
- JP 6506529 B
- JP 2014130344 A
- JP 2018010296 A
- WO 2019039172 A
- WO 2019017280 A
- WO 2018092600 A


### Non-patent literature cited in the description


- **SANTANU PRADHAN ; ALEXANDROS STAVRINADIS ; SHUCHI GUPTA ; YU BI ; FRANCESCO DI STASIO ; GERASIMOS KONSTANTATOS.** Trap-State Suppression and Improved Charge Transport in PbS Quantum Dot Solar Cells with Synergistic Mixed-Ligand Treatments. *Small,* 2017, vol. 13, 1700598